# EUROPEAN PATENT APPLICATION

(11) **EP 4 258 551 A1**
(43) Date of publication of application: **11.10.2023**
(21) Application number: 22167376.7
(22) Date of filing: 08.04.2022
(51) Int. Cl.: H03L 7/08, H03L 7/093, H03L 7/099, H04B 1/40

(54) **METHOD AND SYSTEM FOR CONTROLLING A RESET OF AN OSCILLATOR**

(71) Applicant: u-blox AG, 8800 Thalwil (CH)
(72) Inventor: Beamish, Norman, Cork, T12 E273 (IE)
(74) Representative: Epping - Hermann - Fischer

(57) **Abstract**

A method (400) for controlling a reset of an oscillator includes: receiving (440) at a first time instant an alert that a value of a parameter of the oscillator has reached a threshold value; selecting (450), in response to receiving the alert, a time interval in which to schedule the reset of the oscillator; and initiating (460) at a second time instant the reset of the oscillator, the second time instant occurring within the selected time interval.

## Description

### TECHNICAL FIELD

The field of the present disclosure relates generally to oscillators, and more particularly, to a method and communication apparatus for controlling a reset of an oscillator.

### BACKGROUND OF THE INVENTION

An oscillator is an electrical circuit and a key building block in frequency synthesizers. In such applications, the oscillator typically generates an output signal having a frequency of oscillation which is a function of an input to the oscillator. Hence, the oscillator's output signal, in particular its output frequency, can be dynamically controlled based on the "control" input to the oscillator.

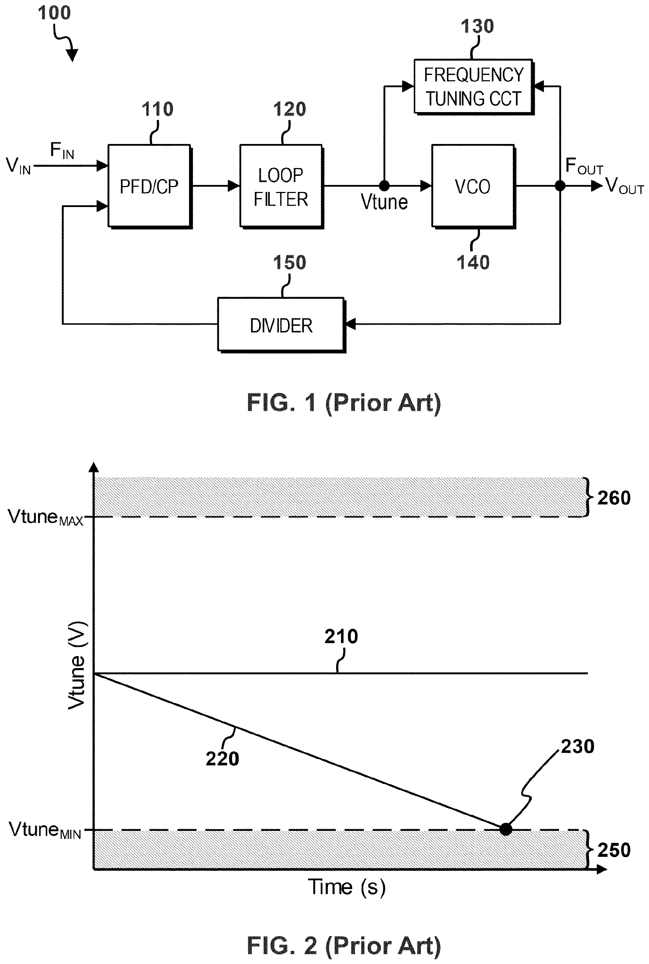

Frequency synthesizers are typically implemented using a phase-locked loop (PLL) circuit. PLLs are well-known in the art and typically come in various flavors. **FIG.** 1 shows a schematic block diagram of an analogue PLL comprised in the state of the art. The PLL 100 includes a phase-frequency detector and charge pump (PFD/CP) 110, a loop filter 120, a frequency tuning circuit 130, a voltage-controlled oscillator (VCO) 140, and a frequency divider 150 connected between the input and output of the PLL 100. As implied by its name, the VCO is an electrical oscillator designed to generate an output signal having an oscillation frequency controlled by a voltage signal applied to the VCO's input. The voltage input signal is sometimes referred to as a control voltage or tuning voltage (Vtune). The PLL typically includes also a trim circuit (not shown) for selecting a particular setting to adjust the voltage-to-frequency operating characteristic of the VCO 140.

The PFD/CP 110 includes a first input configured to receive an input signal V_{IN}, typically from a reference oscillator or clock, and a second input configured to receive a feedback signal from the frequency divider 150. The PFD/CP 110 generates an error signal based on a phase difference and/or frequency difference between the input signal V_{IN} and the output of the divider 150. The loop filter 120 receives the error signal from the PFD/CP 110 and outputs a corresponding control voltage Vtune to the VCO 140 and the frequency tuning circuit 140. The control voltage Vtune is adjusted by the loop filter 120 such that the output frequency F_{OUT} of the output signal V_{OUT} produced at the output of the VCO 140 and thus the PLL 100 matches the input frequency F_{IN} of the input signal V_{IN} by a fixed ratio, determined by the frequency divider 150.

Collectively, the PFD/CP 110, loop filter 120, VCO 140 and frequency divider 150 form a negative feedback loop forcing the frequency of the signal at the output of the frequency divider 150 to track the frequency F_{IN} of the input signal provided to the PFD/CP 110. When the frequency and phase of the output signal of the frequency divider 150 matches that of the input signal V_{IN}, the PLL 100 is said to be "locked" or in "lock" with the input signal.

As already mentioned, PLLs come in different flavors. PLLs may also be realized using a partial or predominantly digital implementation. For instance, in an all-digital PLL (ADPLL), the constituent blocks of the PLL are implemented as digital circuits rather than analogue circuits as discussed above. An ADPLL and analogue PLL operate very similarly except that the ADPLL circuit is controlled by digital signals instead of a voltage or current. Furthermore, the VCO of the analogue PLL is replaced with a digitally-controlled oscillator (DCO). In an ADPLL, the DCO generates an output signal having a frequency of oscillation which is a function of an oscillator tuning word (OTW) applied to the DCO instead of the tuning voltage of a VCO. Similar to an analogue PLL, the loop adjusts the OTW to maintain a locked state in which the frequency and phase of the signal at the output of the divider (or the PLL if there is no frequency divider, i.e. divider ratio is unity) tracks the frequency and phase of the input signal V_{IN}. Implementing a PLL in this way has recently become very attractive owing to the challenges faced with implementing RF circuits in deep submicron CMOS technology, e.g. reduced voltage headroom and compressed linear range for analogue circuits.

Regardless of the implementation however, the oscillator (VCO or DCO) only operates over a finite range of control values applied at its input (tuning voltage or tuning word). Thus, to ensure proper operation of the oscillator, and consequently the PLL 100, it is usually desired to maintain the control voltage Vtune (or OTW) within the operating range of the oscillator employed in the PLL. FIG. 2 illustrates this in the case of the VCO 140 used in PLL 100 for a given frequency F_{OUT} (assumed constant) and shows the influence that temperature can have on the control voltage Vtune over time. The horizontal axis depicts time while the vertical axis depicts the value of control voltage, Vtune (in volts), of the VCO 140.

A voltage range between the minimum tuning voltage Vtune_{MIN} and the maximum tuning voltage Vtune_{MAX} defines the range of control voltages that Vtune can assume for reliable operation. Outside of this range, a first region 250 and a second region 260 are shown where the VCO fails or no longer operates properly. If the temperature of the VCO 140 remains constant over time (all else being equal), then the PLL 100 will maintain a constant control voltage Vtune over time (indicated by horizontal line 210) at the output of the loop filter 120. On the other hand, if the VCO 140 experiences a constant temperature gradient, the feedback loop of the PLL 100 will adapt to compensate for this change, forcing the control voltage Vtune of the VCO 140 to follow a trajectory 220 so that the frequency F_{OUT} remains unaffected. In other words, the PLL 100 is still in lock at this point. If the temperature gradient however persists, this will force the control voltage Vtune to eventually fall outside the valid operating range (Vtune_{MIN}) at point 230. It should be noted that a similar effect arises if the temperature gradient is of an opposite polarity, in which case the control voltage Vtune will increase instead of decreasing as shown in FIG. 2, eventually causing the control voltage to fall outside the upper operating range (Vtune_{MAX}). In either situation, this will result in unpredictable behavior of the VCO 140, thus causing the PLL 100 to lose lock. In turn, if the PLL 100 is operating in a communication device, e.g., a modem or transceiver, during communication, this can result in dropped calls and/or lost data. One way to recover from such an event can be to reset the whole communication device, leading to further downtime of the system or apparatus within which the VCO is operating.

The situation is analogous in an ADPLL. Like the VCO 140, a DCO only operates correctly over a limited range of oscillator tuning words. When the value of the OTW falls outside this valid operating region, the DCO exhibits unpredictable behavior ultimately leading to a loss of lock condition in the ADPLL since the DCO is unable to produce at its output a signal, which after division by the frequency divider 150, tracks the frequency and phase of the input signal V_{IN} to the PLL.

### SUMMARY OF THE INVENTION

An object to be achieved is to provide an improved operating concept that overcomes this drawback of an oscillator operating in a PLL.

This object is achieved with the subject-matter of the independent claims. Embodiments and developments derive from the dependent claims.

The improved operating concept is based on the idea that instead of detecting a situation where an oscillator is operated outside a valid operating region an alert is generated indicating that a parameter of the oscillator is approaching at least one of the boundaries of the operating region. Based on this alert a controlled reset of the oscillator can be initiated, allowing to bring the oscillator into a valid operating region. Furthermore, the time respectively a time interval for such reset can be chosen to minimize any negative effects on circuit parts or operations that depend on the frequency signal generated by the oscillator.

According to a first aspect of the improved operating concept, there is provided a method for controlling a reset of an oscillator, e.g. being part of a PLL, the method including receiving at a first time instant an alert that a value of a parameter of the oscillator has reached a threshold value, selecting, in response to receiving the alert, a time interval in which to schedule the reset of the oscillator and initiating at a second time instant the reset of the oscillator, the second time instant occurring within the selected time interval.

The alert that the value of the oscillator parameter has reached the threshold value may indicate that the oscillator is about to fail or at least not oscillate reliably at a point in time after the first time instant. The alert may take various forms, for example the alert may be an electrical signal, a flag or a status set in a register. The alert may be generated by an apparatus different than the apparatus, e.g., processor, carrying out the steps. The threshold value is a predetermined value of the parameter of the oscillator indicative that the oscillator is still operating but approaching a critical value of the parameter for the oscillator. Rather than letting the oscillator fail, it is advantageous to pre-emptively reset the oscillator before it fails. Controlling the reset of the oscillator in this way not only avoids the oscillator failing while the device (in which the oscillator is located) is involved in communication, e.g., transmitting or receiving data, it also avoids that the device emits spurious emissions resulting from a loss-of-lock of the PLL during oscillator failure. In addition, opportunistically resetting the oscillator may lead to a faster reboot of the oscillator and the communication apparatus in which the oscillator is employed.

The oscillator will require a finite time to undergo a reset. The reset may be a hard reset, functionally like a system power-up, in which the complete communication apparatus is reset. For example, during the hard reset the system's volatile memory is erased and the communication apparatus downloads the configuration settings from non-volatile memory and applies these settings to the applicable components of the system, i.e., not just the oscillator. Alternatively, the reset may be a soft reset in which the reset bypasses the non-volatile memory download process and only initiates reconfiguration of the oscillator's registers. In this way, the communication apparatus in which the oscillator is deployed does not need to undergo a full reset.

A processor within the communication apparatus in which the oscillator is employed e.g. will have knowledge of the scheduled network functions, e.g. transmit or receive functions, allocated to the device by the base station. Armed with this information, the processor is able to choose a suitable time interval for scheduling the reset of the oscillator.

The processor executing instructions to carry out the method outputs a signal used to reset the oscillator either indirectly or directly. In some cases, another system component may be signaled to reset the oscillator, i.e., the output signal triggers another device, which is configured to carry out the reset, to reset the oscillator. In other cases, the output signal is the actual signal directly used to reset the oscillator.

The second time instant occurs after the first time instant but before the point in time the oscillator is about to fail or at least not oscillate reliably. Hence, rather than being allowed to fail, the oscillator undergoes a controlled reset at a suitable or convenient time selected by the processor.

In some implementations the method further includes receiving a measurement of the value of the parameter of the oscillator, comparing the received value of the parameter against the threshold value, and generating the alert based on the received value of the parameter reaching the threshold value.

The alert may be generated within the processor executing the aforementioned steps. In this case the processor executing the code is also configured to receive, e.g. at an input port, a measurement of the value of the parameter of the oscillator and to compare the received value with the threshold value to determine if the oscillator is about to fail. The received value may be a digitized value of an instantaneous value of the oscillator parameter. The alert may be generated if the comparison reveals that the received value exceeds the threshold value. Alternatively, the alert may be generated if the comparison reveals that the received value subsides the threshold value.

The generation of the alert may be based on further conditions, e.g. of other parameters of the oscillator. For example, a measurement of a value of a further parameter of the oscillator is received, wherein generating the alert is further based on the received value of the further parameter.

The parameter and, if applicable, the further parameter of the oscillator may be selected from a control voltage (Vtune), a rate-of-change of the control voltage, an oscillator tuning word, a rate-of-change of the oscillator tuning word, a temperature and a rate-of-change of temperature.

Various parameters of the oscillator may be monitored to provide an indication that the oscillator is about to fail or at least not oscillate in a reliable fashion. For instance, an instantaneous value of a control input of the oscillator may provide information of an imminent failure of the oscillator. In the case of a VCO operating in an analogue PLL, the control input of the oscillator is a tuning or control voltage (Vtune). Alternatively, in the case of a DCO operating in an all-digital PLL, the control input of the oscillator is an oscillator tuning word. In some cases, a condition of the environment in which the oscillator is located may be monitored instead or additionally. A temperature and/or a rate-of-change of temperature in the vicinity of where the oscillator is located may provide an indication of how quickly the oscillator is likely to fail. A higher temperature for instance, will result in a more rapidly decreasing control input to keep the PLL in lock. Evaluation of one or more of such parameters may be combined to generate the alert, as described above.

In some implementations the oscillator is a voltage-controlled oscillator, the parameter of the oscillator comprises a control voltage and the threshold value comprises at least one threshold voltage value.

In the simplest implementation, the threshold value comprises a single threshold voltage value for the tuning or control voltage of the VCO.

The threshold value however may comprise two threshold voltage values, e.g. a first threshold voltage value and a second threshold voltage value, e.g. to define a range of control voltages for the oscillator. For example, the second threshold voltage value is greater than the first threshold voltage value. The first threshold voltage value and the second threshold voltage value define a range of voltage values that the control voltage may assume when the VCO is operating reliably. If the control voltage of the VCO falls outside this range, it may indicate that the VCO is about to fail or at least no longer operate reliably.

The first threshold voltage value may define a lower voltage bound and the second threshold voltage value may define an upper voltage bound. The first threshold voltage value e.g. is greater than a predefined minimum tuning voltage of the VCO, e.g. tuning voltage Vtune_{MIN} as described in the introductory part of this disclosure. The second threshold voltage value e.g. is less than a predefined maximum tuning voltage of the VCO, e.g. tuning voltage Vtune_{MAX} as also described in the introductory part of this disclosure. If the control voltage of the VCO falls outside the range defined by the first and second threshold voltage values, it is indicative that the VCO, if left uncontrolled, may fall below or exceed the minimum tuning voltage or the maximum tuning voltage, respectively, thereby leading to failure of the VCO.

In some other implementations the oscillator is a digitally-controlled oscillator, the parameter of the oscillator comprises an oscillator tuning word and the threshold value comprises at least one threshold tuning word value.

In the case of a DCO, the simplest implementation is the threshold value comprising a single threshold tuning word value for the oscillator tuning word of the DCO.

However, the threshold value may comprise a first threshold tuning word value and a second threshold tuning word value. For example, the first threshold tuning word is different to the second threshold tuning word. The first threshold tuning word and the second threshold voltage value define a range of digital control words that the oscillator tuning word may assume when the DCO is operating reliably. The second threshold tuning word value e.g. is greater than the first threshold tuning word value. If the oscillator tuning word of the DCO falls outside this range, it may indicate that the DCO is about to fail.

The first threshold tuning word value defines a lower bound for the digital control word taken on by the oscillator tuning word. Similarly, the second threshold tuning word value defines an upper bound for the digital control word that can be assumed by the oscillator tuning word. The first threshold tuning word value e.g. is greater than a predefined minimum tuning word of the DCO. The second threshold tuning word value e.g. is less than a predefined maximum tuning word of the DCO. If the tuning word of the DCO falls outside the range defined by the first and second threshold tuning word values, it is indicative that the DCO, if left uncontrolled, may fall below or exceed the minimum tuning word or the maximum tuning word, respectively, thereby leading to failure of the DCO.

The step of selecting the time interval may comprise identifying a time slot comprising a duration at least as long as a reset time needed to reset the oscillator. For example, the oscillator is coupled to at least one signal path selected from a receiver signal path and a transmitter signal path. In such configuration the step of selecting the time interval may further comprise identifying a time slot where the at least one signal path is inactive.

The processor within the communication apparatus in which the oscillator is employed will have knowledge of the scheduled network functions, e.g. transmit or receive functions, allocated to the transceiver. To avoid dropped calls or minimize data being lost during communication, the processor may identify a suitable time slot in which to reset the oscillator. The identified time slot will typically be a slot where the communication apparatus is not scheduled to transmit data to the network (uplink transmission) or receive data from the network (downlink transmissions) such that the respective signal path, i.e. transmit path or receive path, is inactive. The processor may determine from the scheduling of network functions that there are several suitable time slots. Preferably, the identified time slot has a time duration at least as long as the length of time needed to reset the oscillator. In this way, interruptions to downlink or uplink transmissions is minimized.

In some implementations the selected time interval corresponds to a first time slot of the identified time slots occurring after the first time instant. For example, in the situation where the processor determines from the scheduling of network functions for the communication apparatus that there are several suitable time slots for initiating a reset of the oscillator, the processor may select the first suitable time slot for initiating the reset of the oscillator.

In some implementations the selected time interval comprises a guard period or a gap in transmissions. For example, in selecting the time interval, the processor may exploit a gap in transmissions or a guard period in the scheduled transmissions of the communication apparatus. A guard period, also known as a guard interval, is a time interval deliberately introduced during which no radio transmission can occur. It provides a safety margin against symbol interference in the time between sequential transmission operations.

In some implementations the step of initiating the reset of the oscillator comprises signaling that configuration information be used to reset the oscillator and the reset time needed to reset the oscillator correspond to a soft reset. Instead of initiating a hard reset, i.e., erasing the present operational settings for the oscillator in volatile memory and downloading the default oscillator settings from non-volatile memory, the processor may elect to initiate a "soft" reset of the oscillator. A soft reset bypasses the non-volatile memory download process and only initiates the reconfiguration of the registers. For instance, rather than initiating a complete reset of the oscillator, the capacitor array of the oscillator may be instructed to change by one LSB. This will move the operating point of the oscillator away from the point of failure. Applying a soft reset instead of a hard reset has the advantage that the time needed to reset the oscillator will be much quicker and thus a long downtime for the communication apparatus in which the oscillator is located is avoided. Accordingly, a time slot of shorter duration in which to reset the oscillator can be selected.

For example, the second time instant substantially coincides with the beginning of the selected time interval. If the duration of the selected time interval is comparable to the length of time needed to reset the oscillator, the processor may preferably initiate the reset of the oscillator at a second time instant which coincides or substantially coincides with the start of the selected time interval. In this way, the reset (and subsequent restarting) of the oscillator is completed within the selected time interval. This minimizes the impact of resetting the oscillator to the continuation of services linked to scheduled downlink or uplink transmissions.

In another aspect of the improved operating concept there is disclosed a communication apparatus comprising a PLL including an oscillator, at least one processor, and a storage medium storing instructions, which when executed by the at least one processor, cause the apparatus to carry out the method according to one of the implementations described above to control a reset of the oscillator (140, 340).

The communication apparatus may be a transceiver, for example a transceiver apparatus for a cellular network. The at least one processor may be a baseband processor of the transceiver. In some implementations, the communication apparatus will comprise a single oscillator respectively PLL for both the receive path and the transmit path. The baseband processor may execute instructions to carry out the method in respect of the single oscillator. In other implementations the communication apparatus will comprise more than one oscillator respectively PLL. For instance, there may be one PLL for the transmitter chain and a separate PLL for the receiver chain. The baseband processor may execute instructions to carry out the method in respect of both oscillators, i.e. the oscillator in the PLL for the transmitter chain and the oscillator in the PLL for the receiver chain.

The communication apparatus may include respective means for measuring the value of the at least one parameter of the oscillator and for providing such values to the processor. Furthermore, the communication apparatus may include a memory for storing transmission parameters for supporting the selection of the time interval in which to schedule the reset of the oscillator.

It is to be understood that the foregoing general description and the following detailed description are exemplary and explanatory only, and are not restrictive of the invention, as claimed.

### BRIEF DESCRIPTION OF THE DRAWINGS

**FIG.** 1 and **FIG.** 2 were described in connection with the background to the invention (see above).
   The improved operating concept will now be described by way of example with reference to the accompanying drawings, in which:
**FIG. 3** illustrates an exemplary communication apparatus according to one aspect of the improved operating concept.
**FIG. 4** is a flow chart illustrating an exemplary method for controlling a reset of an oscillator, according to another aspect of the improved operating concept.
**FIG. 5** illustrates an exemplary tuning range for an oscillator, according to one aspect of the improved operating concept.
**FIG. 6** illustrates an exemplary radio frame structure, according to another aspect of the improved operating concept.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the improved operating concept. Instead, they are merely examples of apparatuses and methods consistent with aspects related to the improved operating concept as recited in the appended claims.

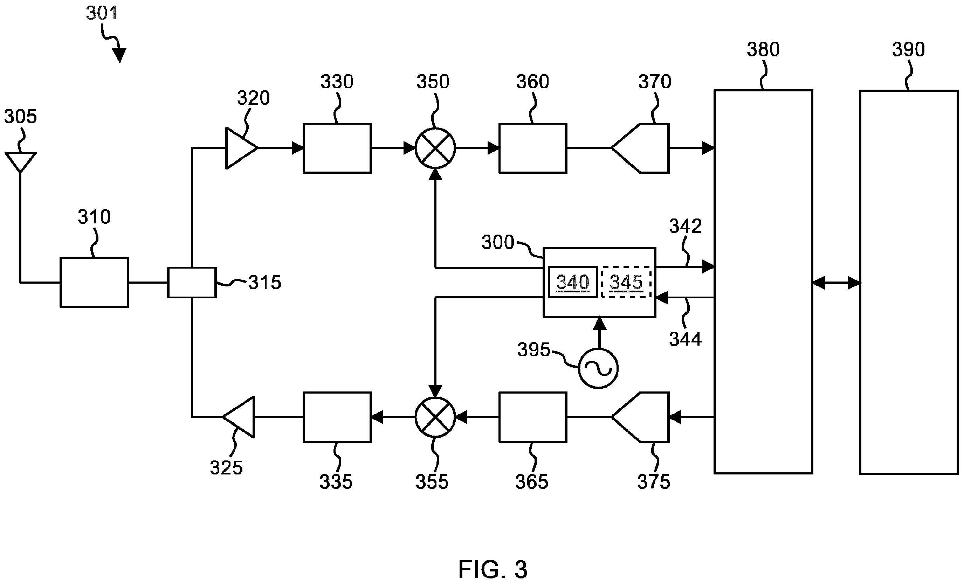

**FIG. 3** illustrates an exemplary communication apparatus according to one aspect of the improved operating concept. The communication apparatus may for instance be a transceiver 301 used in cellular network. Furthermore, the transceiver may employ time division duplexing (TDD) provided for according to the Long-Term Evolution (LTE^{®}) communication standard. Thus, the transceiver 301 may be used for a TDD communication system that transmits data on the downlink (DL) and uplink (UL) on the same frequency band at different times. As shown in **FIG. 3****,** the exemplary transceiver 301 comprises a receive path and a transmit path shown in the top and bottom part of the diagram, respectively.

The transceiver invariably includes an antenna 305 for receiving and transmitting cellular signals from and to a cellular base station, e.g. a eNodeB. The antenna 305 is coupled to an RF filter 310 which is further coupled to a switch 315 which acts as a duplexer to switch between the receive path and the transmit path. In this way the transceiver operates as a receiver or a transmitter, depending on the selection imposed by switch 315. In other arrangements, the transceiver 301 may use a separate antenna for transmission and reception, thereby dispensing with the need for switch 315.

In the receive path, a low-noise amplifier (LNA) 320 receives the filtered RF signal from the switch 315. The LNA 320 amplifies the signal received without substantially increasing the noise contained in the signal and provides a conditioned signal having a desired signal level to a filter 330. A mixer 350 multiplies the received signal from the filter 330 with a local oscillator (LO) signal from a PLL 300, thereby frequency translating the received signal to provide a downconverted signal to a low-pass filter 360. The low-pass filter 360 processes the downconverted signal to pass the desired signal components and to remove noise and undesired signals that may be generated by the downconversion process. The low-pass filter 360 may also perform an anti-aliasing function. An analogue-to-digital converter 370 digitizes the downconverted signal and provides a stream of samples to a processor 380. The processor 380 is coupled to a memory unit 390 for storing data and executable program code used by the processor 380. The memory unit 390 may be a random access memory (RAM) and/or a read only memory (ROM).

In the transmit path, a digital-to-analogue converter 375 receives a stream of digital samples (which constitutes the baseband input signal to be transmitted) from the processor 380, converts the stream to an analogue signal thereby providing an analogue baseband signal. A second low-pass filter 365 processes the analogue baseband signal to remove undesired frequency components generated during the digital-to-analogue conversion and provides a filtered baseband signal. A second mixer 355 multiplies the filtered baseband signal with a second LO signal from the PLL 300 to frequency translate the filtered baseband signal and provide an upconverted signal. A further filter 335 processes the upconverted signal to remove any undesired frequency components, e.g. out-of-band noise, in the upconverted signal before transmission. A power amplifier 325 amplifies the filtered upconverted signal received from the further filter 335 and provides an RF modulated signal which is routed to the antenna 305 via switch 315 for transmission.

The transmit and receive paths may each include one or more stages of amplification, filtering, mixing, and so on. For instance, rather than providing one stage of frequency translation, the transmit path and/or the receive path may provide one or more additional stages of frequency upconversion or downconversion. The transmit and receive paths may also include fewer, different, and/or additional circuit blocks not shown in the communication apparatus of **FIG. 3****.** For example, as mentioned above switch 315 in **FIG. 3** may be omitted, and the transmit and receive paths may be connected to separate antennas.

The PLL 300 generates the signal used to derive the previously mentioned local oscillator (LO) signal of the receive path and the second LO signal of the transmit path. The PLL 300 comprises a loop which includes an oscillator 340 at the output of the PLL 300. For providing the two LO signals the PLL 300 may include a switch for providing the oscillator signal of the oscillator 340 either to mixer 350 or to mixer 355. The oscillator 340 may be a voltage-controlled oscillator (VCO) or a digitally-controlled oscillator (DCO). A reference oscillator 395 supplies a reference signal to the input of the PLL 300. When locked, the PLL 300 generates the oscillator signal which e.g. matches the frequency and phase of the reference signal from reference oscillator 395, or a signal derived thereof. The reference oscillator 395 may be a temperature compensated oscillator (TCXO).

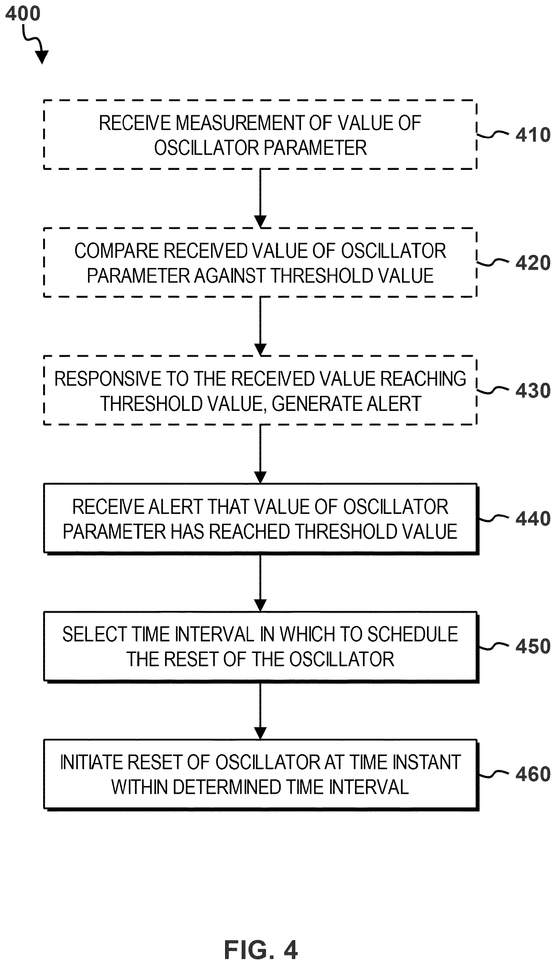

A signal 342 can be transmitted from the PLL 300 to the processor 380 carrying an alert or a parameter of the oscillator 340 respectively a value of such parameter. A further signal 344 transmitted from the processor 380 to the PLL 300 can be used to control or at least initiate a reset of the oscillator 340 or the PLL 300. Signals 342 and 344 will be explained in more detail in conjunction with **FIG. 4** below.

In another arrangement, the transceiver 301 respectively the PLL 300 may comprise two separate PLL circuits to generate independent LO signals for the receive path and the transmit path. This may for example allow implementation of a Frequency Division Duplex (FDD) system where signals are transmitted with a frequency different to a frequency of received signals.

Similarly to signal 342, each PLL circuit may comprise separate signals for forwarding an alert or parameter from the PLL to the processor 380. Likewise, similarly to signal 344, each PLL circuit may receive separate signals to control or at least initiate a reset of the respective oscillator or PLL.

In some arrangements, the PLL 300 may optionally comprise a temperature sensor 345 for sensing a temperature parameter of the oscillator 340 within the PLL 300. For example, the temperature sensor 345 may monitor a temperature parameter by measuring the temperature or rate of change of temperature at an on-chip location in proximity to the oscillator 340. The measured value of the temperature parameter may be compared against a threshold temperature value, and in response to the measured value of the temperature breaching the threshold value, an alert may be generated and forwarded to the processor 380 via signal 342. Alternatively, the measured temperature parameter may be digitized and forwarded to the processor 380 via signal 342. Upon receipt of the digitized temperature measurement, the processor 380 may compare the value of the measurement against a threshold temperature value. Responsive to the compared value crossing the threshold temperature value, the processor 380 may generate an alert to indicate that the oscillator temperature has reached a threshold value.

**FIG. 4** is a flow chart illustrating an exemplary method for controlling a reset of an oscillator, according to another aspect of the improved operating concept.

In optional step 410 a measurement of a value of a parameter of an oscillator, e.g. oscillator 340, is received. In some implementations this value is transmitted over signal 342 as shown in **FIG. 3****.** The value is compared against a threshold value in optional step 420.

Various parameters of the oscillator may be monitored to indicate that the oscillator is about to fail or at least not oscillate in a reliable manner. For instance, an instantaneous value of a control input of the oscillator may provide information of an imminent failure of the oscillator. In the case of a VCO operating within an analogue PLL of the communication apparatus, the oscillator's control voltage Vtune may be monitored and compared against a threshold voltage value. If the instantaneous value of the control voltage Vtune breaches the predetermined threshold, it may indicate that the VCO is about to fail. Alternatively, or in addition to monitoring the VCO's control voltage Vtune, the rate of change of the VCO's control voltage may be monitored and compared against a predetermined threshold rate-of-change value. If the rate of change of the control voltage crosses the threshold, it may be indicative that the VCO is about to fail. In such case an alert can be generated in optional step 430.

In the case of a DCO operating within an all-digital PLL of the apparatus, an oscillator tuning word of the DCO may be monitored and compared against a predetermined threshold tuning word value. If the instantaneous value of the oscillator tuning word crosses the predetermined threshold, it may indicate an imminent failure of the DCO. Like in the VCO implementation in such case an alert can be generated in optional step 430.

In some situations, a condition of the environment in which the oscillator is located may be monitored instead of, or in addition to, the above parameters. For example, a temperature and/or a rate-of-change of the temperature in the vicinity of the on-chip location of the oscillator may provide an indication of how quickly the oscillator is likely to fail. A high temperature or rate-of-change of temperature for instance, will typically indicate that the control input of the oscillator will follow a steep trajectory in order to keep the PLL (or ADPLL) in lock. Thus, in some implementations, it may be advantageous to monitor the temperature and/or rate-of-change of temperature of the oscillator or a nearby on-chip component to generate and provide an alert of imminent failure of the oscillator, which can be part of optional step 430.

The comparison of the monitored parameter need not be confined to a single threshold value. In fact, it may be advantageous to define two different threshold values for a particular parameter to be monitored and compare the parameter against each of the predetermined threshold values. The difference between the larger threshold value and the smaller threshold value defines a range of values for the monitored parameter. In this way an alert can be generated in response to the monitored parameter falling outside the range defined by the two threshold values.

Evaluation of the value of the oscillator parameter including generation of the alert e.g. can be performed in processor 380. As mentioned above the measured value can be transmitted over signal 342 as shown in **FIG. 3****.** However, evaluation of the value and generation of the alert could be performed in the PLL itself, such that the alert is transmitted to the processor 380 over signal 342.

Either way, referring back to **FIG. 4****,** the alert that the value of the parameter of the oscillator has reached the threshold value is received in step 440, e.g. at a first time instant.

Step 450 includes selecting, in response to receiving the alert, a time interval in which to schedule the reset of the oscillator. The step 450 of selecting the time interval may comprise identifying a time slot comprising a duration at least as long as a reset time needed to reset the oscillator. For example, the oscillator is coupled to at least one signal path selected from a receiver path and a transmitter path. In such configuration the step 450 of selecting the time interval may further comprise identifying a time slot where the at least one signal path is inactive.

The processor 380 within the communication apparatus in which the oscillator 340 is employed will have knowledge of the scheduled network functions, e.g. transmit or receive functions, allocated to the transceiver. To avoid dropped calls or minimize data being lost during communication, the processor may identify a suitable time slot in which to reset the oscillator. The identified time slot will typically be a slot where the communication apparatus is not scheduled to transmit data to the network (uplink transmission) or receive data from the network (downlink transmissions). The processor may determine from the scheduling of network functions that there are several suitable time slots. Preferably, the identified time slot has a time duration at least as long as the length of time needed to reset the oscillator. In this way, interruptions to downlink or uplink transmissions is minimized.

In some implementations the selected time interval corresponds to a first time slot of the identified time slots occurring after the first time instant. For example, in the situation where the processor determines from the scheduling of network functions for the communication apparatus that there are several suitable time slots for initiating a reset of the oscillator, the processor may select the first suitable time slot for initiating the reset of the oscillator.

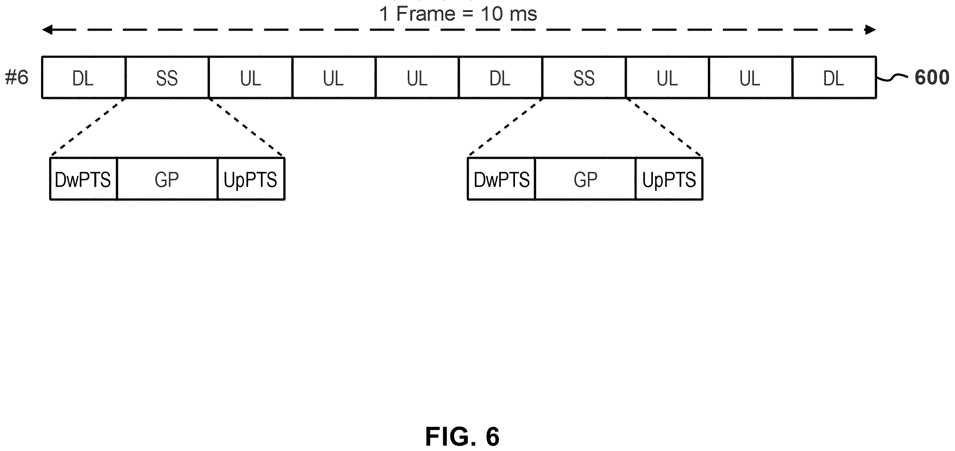

The selected time interval may comprise a guard period or a gap in transmissions. For example, in selecting the time interval, the processor may exploit a gap in transmissions or a guard period in the scheduled transmissions of the communication apparatus. A guard period, also known as a guard interval, is a time interval deliberately introduced during which no radio transmission can occur. It provides a safety margin against symbol interference in the time between sequential transmission operations. This will be described in more detail as an example in conjunction with **FIG. 6****.**

Step 460 includes initiating at a second time instant the reset of the oscillator, the second time instant occurring within the selected time interval. This may comprise sending a respective indication over signal 344 to the PLL 300 respectively the oscillator 340. For example, a processor 380 executing instructions to carry out the method 400 outputs a signal 344 used to reset the oscillator 340 either indirectly or directly. In some cases, another system component may be signaled to reset the oscillator 340, i.e., the output signal triggers another device, which is configured to carry out the reset, to reset the oscillator. In other cases, the output signal 344 is the actual signal directly used to reset the oscillator.

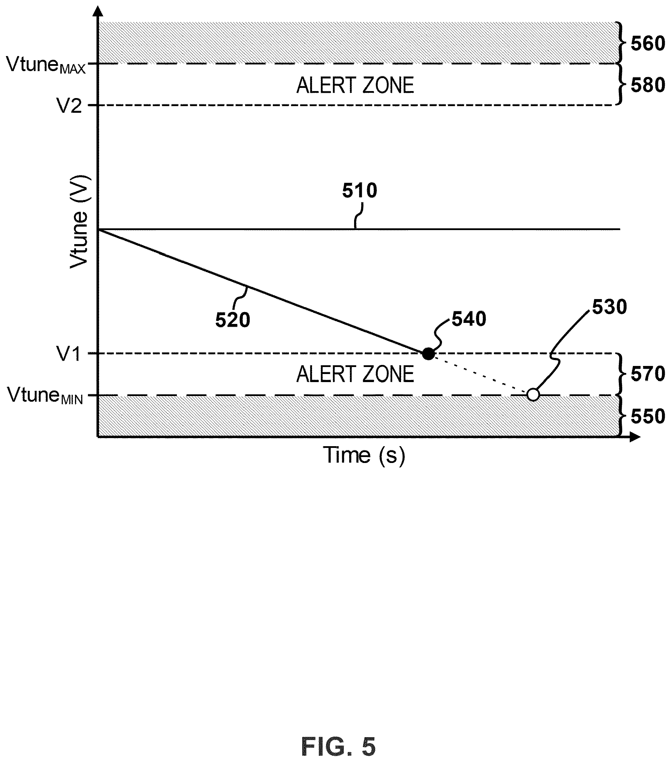

**FIG. 5** illustrates an exemplary tuning range for a VCO, according to one aspect of the improved operating concept. As with **FIG. 2****,** the horizontal axis and the vertical axis of **FIG. 5** depict time and the oscillator control voltage Vtune in volts (V), respectively. As before, the VCO also has a minimum tuning voltage Vtune_{MIN} as well as a maximum tuning voltage Vtune_{MAX} which define the voltage range Vtune_{MAX} - Vtune_{MIN} that a value of the control voltage Vtune can assume for reliable operation. Outside of this range, a first region 550 and a second region 560 are shown where the VCO fails or no longer operates in a reliable manner. By definition, Vtune_{MAX} is greater than Vtune_{MIN}.

According to one aspect of the improved operating concept, a first threshold voltage value V1 is defined which is set above the minimum tuning voltage Vtune_{MIN} that the VCO's control voltage Vtune can assume before it fails. Furthermore, a second threshold voltage value V2 is defined which is set below the maximum tuning voltage Vtune_{MAX} that the VCO's control voltage Vtune can assume before the oscillator fails. Hence, the voltage range V2 - V1 is a subset of the voltage range defined by Vtune_{MAX} - Vtune_{MIN}.

Values of the control voltage Vtune between the minimum tuning voltage Vtune_{MIN} and the first threshold voltage value V1 define a first alert zone 570. Similarly, values of the control voltage Vtune between the maximum tuning voltage Vtune_{MAX} and the second threshold voltage value V2 define a second alert zone 580. Accordingly, if the value of the control voltage Vtune crosses into the first alert zone or the second alert zone, an alert is triggered which indicates that failure or unpredictable operation of the VCO is imminent.

If, all else being equal, the temperature of the VCO remains constant, the PLL will maintain over time a constant control voltage Vtune (indicated by horizontal line 510) at the oscillator's output. On the other hand, if the VCO experiences a constant temperature gradient, the feedback loop of the PLL will adapt to compensate for this change such that the output frequency F_{OUT} doesn't change, thereby forcing the control voltage Vtune of the VCO to follow a trajectory 520. In other words, the PLL remains locked for as long as the control voltage Vtune of the VCO stays within the voltage range defined by Vtune_{MAX} - Vtune_{MIN}. If the temperature gradient persists however, this will force the control voltage Vtune to eventually reach the first threshold voltage value V1 indicated at point 540. At this point an alert is generated signaling that, if no preemptive action is taken, the oscillator's control voltage Vtune will eventually reach the minimum tuning voltage Vtune_{MIN} at point 530, causing the VCO to either fail or not oscillate reliably, thus leading to the PLL losing lock.

Although the above discussion is in relation to a VCO, the skilled person will appreciate that the arrangement can be adapted for a DCO by defining a first threshold tuning word value and a second threshold tuning word value in place of the first threshold voltage value and the second threshold voltage value, respectively. In principle, the only difference in operation is that a DCO is controlled by a digital control word instead of an analogue control voltage at the input of the oscillator. Since the control word for the DCO is a discrete value, this implies that the minimum tuning voltage Vtune_{MIN} and the maximum tuning voltage Vtune_{MAX} are also discrete digital values.

**FIG. 6** illustrates an exemplary radio frame structure used in a time division duplexing (TDD) system for Long Term Evolution (LTE^{®}), a modern cellular communication standard. A TDD frame in LTE^{®} typically comprises a downlink subframe DL, an uplink subframe UL and a special subframe SS. As shown, the 10-millisecond (ms) radio frame 600 consists of three distinct downlink subframes, five distinct uplink subframes and two distinct special subframes. However other frame configurations are possible. For instance, an operator can choose from seven specific TDD frame configurations based on different DL/UL partitioning depending on the service requirements.

The downlink subframe DL denotes the scheduling of a DL transmission from the eNodeB to the transceiver communication apparatus. A TDD frame in LTE always starts with a downlink subframe DL to advertise the frame descriptor information, i.e. the physical control format indicator channel (PCFICH) and the physical downlink control channel (PDCCH). Hence, the UE learns the frame structure in the subframe from the very first subframe of each TDD frame.

Similarly, the uplink subframe UL denotes the scheduling of uplink transmissions from the UE to the eNodeB. In LTE, the third subframe of TDD frames are always used for UL transmission. In TDD a single frequency is shared in the time domain between UL and DL transmissions.

As shown, the radio frame 600 consists of a special subframe SS in the second and seventh subframe positions. The special subframe SS is required when switching the transmission from downlink to uplink. As illustrated in **FIG. 6****,** each special subframe SS of the TDD frame 600 consists of three parts, namely a downlink pilot time slot (DwPTS), a guard period GP and an uplink pilot time slot (UpPTS), all of which have configurable lengths set by the network. The guard period GP is used to control the switching from DL transmission to UL transmission and to ensure all UL transmissions from the multiple UEs in the network arrive at the same time at the eNodeB transceiver.

Since no UL transmissions or DL transmissions occur during the guard period GP, it provides a suitable time interval for scheduling the reset of the oscillator. Hence, according to one aspect of the improved operating concept, the processor selects a guard period time interval for scheduling the reset of the oscillator. In this manner, communication between the UE and eNodeB (in either direction) is not affected.

The embodiments of the improved operating concept disclosed herein have been discussed for the purpose of familiarizing the reader with novel aspects of the implementation of the improved operating concept. Although preferred embodiments have been shown and described, many changes, modifications, equivalents and substitutions of the disclosed concepts may be made by one having skill in the art without unnecessarily departing from the scope of the claims.

In particular, the implementation of the improved operating concept is not limited to the disclosed embodiments, and gives examples of many alternatives as possible for the features included in the embodiments discussed. However, it is intended that any modifications, equivalents and substitutions of the disclosed concepts be included within the scope of the claims which are appended hereto.

Features recited in separate dependent claims may be advantageously combined. Moreover, reference signs used in the claims are not limited to be construed as limiting the scope of the claims.

Furthermore, as used herein, the term "comprising" does not exclude other elements. In addition, as used herein, the article "a" is intended to include one or more than one component or element, and is not limited to be construed as meaning only one.

## Claims

1. A method (400) for controlling a reset of an oscillator, the method comprising:
receiving (440) at a first time instant an alert that a value of a parameter of the oscillator has reached a threshold value;
selecting (450), in response to receiving the alert, a time interval in which to schedule the reset of the oscillator; and
initiating (460) at a second time instant the reset of the oscillator, the second time instant occurring within the selected time interval.

2. The method according to claim 1, further comprising:
receiving (410) a measurement of the value of the parameter of the oscillator;
comparing (420) the received value of the parameter against the threshold value; and
generating (430) the alert based on the received value of the parameter reaching the threshold value.

3. The method according to claim 2, further comprising
receiving (410) a measurement of a value of a further parameter of the oscillator; wherein
generating (430) the alert is further based on the received value of the further parameter.

4. The method according to one of claims 1 to 3, wherein the parameter of the oscillator is selected from: a control voltage (Vtune), a rate-of-change of the control voltage, an oscillator tuning word, a rate-of-change of the oscillator tuning word, a temperature and a rate-of-change of temperature.

5. The method according to one of claims 1 to 4, wherein the oscillator is a voltage-controlled oscillator and the parameter of the oscillator comprises a control voltage (Vtune) and the threshold value comprises at least one threshold voltage value (V1, V2).

6. The method according to claim 5, wherein the threshold value comprises a first threshold voltage value (V1) and a second threshold voltage value (V2), and wherein the second threshold voltage value (V2) is greater than the first threshold voltage value (V1).

7. The method according to one of claims 1 to 4, wherein the oscillator is a digitally-controlled oscillator and the parameter of the oscillator comprises an oscillator tuning word and the threshold value comprises at least one threshold tuning word value.

8. The method according to claim 7, wherein the threshold value comprises a first threshold tuning word value and a second threshold tuning word value, and wherein the second threshold tuning word value is greater than the first threshold tuning word value.

9. The method according to one of claims 1 to 8, wherein the step of selecting the time interval comprises identifying a time slot comprising a duration at least as long as a reset time needed to reset the oscillator.

10. The method according to claim 9, wherein the oscillator is coupled to at least one signal path selected from a receiver signal path and a transmitter signal path and wherein the step of selecting the time interval comprises identifying a time slot where the at least one signal path is inactive.

11. The method according to claim 9 or 10, wherein the selected time interval corresponds to a first time slot of the identified time slots occurring after the first time instant.

12. The method according to one of claims 9 to 11, wherein the selected time interval comprises a guard period (GP) or a gap in transmissions.

13. The method according to one of claims 9 to 12, wherein the step of initiating (240) the reset of the oscillator comprises signaling that configuration information be used to reset the oscillator and the reset time needed to reset the oscillator correspond to a soft reset.

14. The method according to one of claims 1 to 13, wherein the second time instant substantially coincides with the beginning of the selected time interval.

15. A communication apparatus (301) comprising:
a phase-locked loop (100, 300) including an oscillator (140, 340);
at least one processor (380); and
a storage medium (390) storing instructions, which when executed by the at least one processor (380), cause the apparatus to carry out the method according to one of claims 1 to 14 to control a reset of the oscillator (140, 340).
